# EUROPEAN PATENT APPLICATION

(11) **EP 4 766 074 A1**
(43) Date of publication of application: **24.06.2026**
(21) Application number: 25184722.4
(22) Date of filing: 24.06.2025
(51) Int. Cl.: H10D 10/80, H10D 62/17, H10D 84/01, H10D 84/60, H10D 84/03, H10D 84/67

(54) **BIPOLAR TRANSISTORS WITH A COMMON EXTRINSIC BASE REGION**

(30) Priority: 20.12.2024 US 202418990481
(71) Applicant: GlobalFoundries U.S. Inc., Malta, NY 12020 (US)
(72) Inventor: DeAngelis, Jacob Matthew, Essex Junction, VT 05452 (US); Shank, Steven M., Essex Junction, VT 05452 (US); Raghunathan, Uppili Srinivasan, Essex Junction, VT 05452 (US); McTaggart, Sarah Ann, Essex Junction, VT 05452 (US); Lydon-Nuhfer, Megan Elizabeth, Essex Junction, VT 05452 (US)
(74) Representative: Grünecker Patent- und Rechtsanwälte PartG mbB

(57) **Abstract**

The present disclosure relates to heterojunction bipolar transistors with a common extrinsic base, and methods of manufacture. The structure includes: a first transistor (100) having an intrinsic base (14a), an extrinsic base (12a) and an emitter (32a); and a second transistor (200) having an intrinsic base (14b), an extrinsic base (12b) and an emitter (32b). The extrinsic base (12a) of the first transistor and the extrinsic base (12b) of the second transistor have a common extrinsic base region (12a, b, c) with a first dopant type for the first transistor and a second opposite dopant type for the second transistor.

## Description

### BACKGROUND

The present disclosure relates to semiconductor structures and, more particularly, to heterojunction bipolar transistors and methods of manufacture.

A heterojunction bipolar transistor (HBT) is a type of bipolar junction transistor (BJT) which uses differing semiconductor materials for the emitter and base regions or collector and base regions, creating a heterojunction. HBTs are used in power amplifier and cellular applications, amongst others, and require low collector-base capacitance (Ccb), low base resistance (Rb), high cut-off frequencies (fT/fmax) and high breakdown voltage (BVceo). Current integration schemes for fabricating the HBT result in high Ccb (parasitic capacitance) and high Rb, which is a concern in bipolar technologies as it limits device scaling for improved fT/fmax.

### SUMMARY

In an aspect of the disclosure, a structure comprises: a first transistor comprising an intrinsic base, an extrinsic base and an emitter; and a second transistor comprising an intrinsic base, an extrinsic base and an emitter. The extrinsic base of the first transistor and the extrinsic base of the second transistor comprise a common extrinsic base layer with a first dopant type for the first transistor and a second dopant type for the second transistor.

In an aspect of the disclosure, a structure comprises: a first heterojunction bipolar transistor comprising an emitter with a first dopant type, an extrinsic base with a second dopant type and a sub-collector region with the first dopant type; and a second heterojunction bipolar transistor comprising an emitter with the second dopant type, an extrinsic base with the first dopant type and a sub-collector region with the second dopant type. The extrinsic base of the first heterojunction bipolar transistor and the extrinsic base of the second heterojunction bipolar transistor comprise a common and continuous semiconductor layer.

In an aspect of the disclosure, a method comprises: forming a first transistor comprising an intrinsic base, an extrinsic base and an emitter; and forming a second transistor an intrinsic base, an extrinsic base and an emitter, wherein the extrinsic base of the first transistor and the extrinsic base of the second transistor are formed with a common extrinsic base layer with a first dopant type for the first transistor and a second dopant type for the second transistor.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a structure and respective fabrication processes in accordance with aspects of the present disclosure.
FIG. 2 shows a structure and respective fabrication processes in accordance with additional aspects of the present disclosure.
FIG. 3 shows a structure and respective fabrication processes in accordance with further aspects of the present disclosure.
FIG. 4 shows a flow diagram representative of processes to fabricate the structures described herein in accordance with aspects of the present disclosure.

### DETAILED DESCRIPTION

The present disclosure relates to semiconductor structures and, more particularly, to heterojunction bipolar transistors and methods of manufacture. More specifically, the bipolar transistors may be coplanar complementary bipolar transistors. In embodiments, the complementary bipolar transistors comprise a shared common, continuous and coplanar base region, e.g., (extrinsic base film or layer). Advantageously, the bipolar transistors provide a compact complementary inverter layout with significant area savings over conventional devices. For example, the collector contact space is reduced significantly from conventional devices. Moreover, the bipolar transistors will eliminate NPN-PNP residuals around a protected device and, hence, increase device performance, e.g., fmax.

In more specific embodiments, the bipolar devices may be complementary (NPN/PNP) heterojunction bipolar transistors with a common (e.g., continuous and coplanar) extrinsic base layer with two different doping regions (e.g., N-doped region and P-doped region). The complementary heterojunction bipolar transistors may have two different intrinsic base doping (e.g., N-type doping/P-type doping), with two different emitter doping and two different sub-collector wells. The doped extrinsic base regions can be silicided and shorted together with a common base contact to enable circuit functions such as an inverter. Also, in embodiments, a PNP transistor can have a triple-well isolation beneath the sub-collector region.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

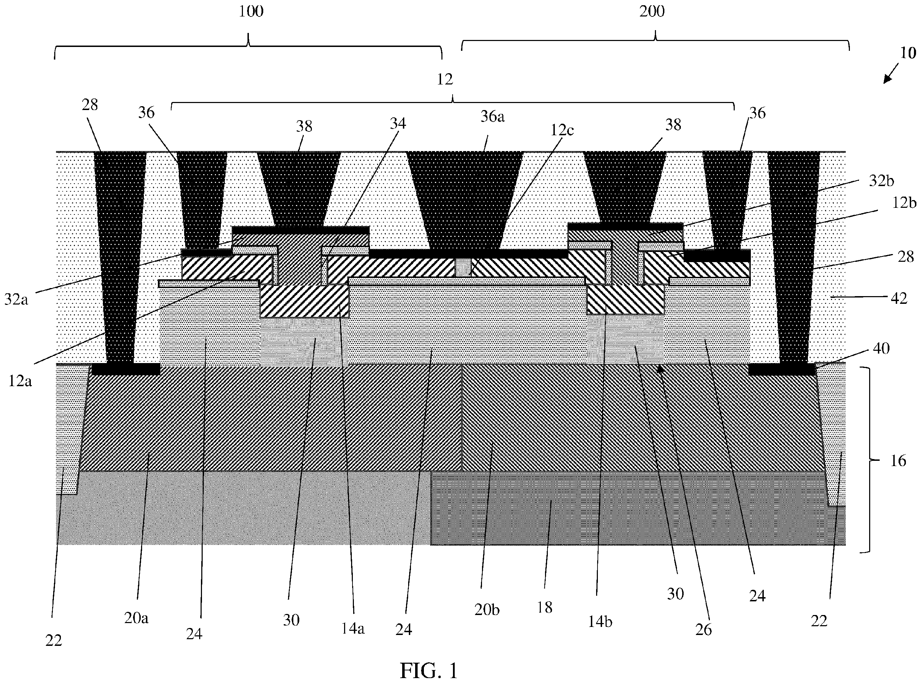

FIG. 1 shows a structure and respective fabrication processes in accordance with aspects of the present disclosure. The structure 10 of FIG. 1 includes complementary heterojunction bipolar transistors 100, 200 with a shared extrinsic base region 12. In embodiments, the shared extrinsic base region 12 may be planar and

comprises different doping (e.g., N-type doping and P-type doping) for each of the complementary heterojunction bipolar transistors 100, 200. For example, in embodiments, the heterojunction bipolar transistor 100 may be a PNP with an extrinsic base region 12a comprising a P-type doping, e.g., Boron; whereas the heterojunction bipolar transistor 200 may be an NPN with an extrinsic base region 12b comprising an N-type doping, e.g., Arsenic. Similarly, the intrinsic base regions 14a, 14b of the heterojunction bipolar transistors 100, 200 may have different doping. For example, the heterojunction bipolar transistor 100 may have an intrinsic base region 14a comprising a P-type doping, e.g., Boron; whereas the heterojunction bipolar transistor 200 may be an NPN with an intrinsic base region 14b comprising an N-type doping, e.g., Arsenic.

More specifically, the structure 10, e.g., heterojunction bipolar transistors 100, 200, may include a semiconductor substrate 16. The semiconductor substrate 16 may be composed of any suitable material including, but not limited to, Si, SiGe, SiGeC, SiC, GaAs, InAs, InP, and other III/V or II/VI compound semiconductors. The semiconductor substrate 16 may be a single crystalline semiconductor material that comprises any suitable crystallographic orientation (e.g., a (100), (110), (111), or (001) crystallographic orientation). In embodiments, the semiconductor substrate 16 may be a p-type substrate. The semiconductor substrate 16 may be bulk substrate or semiconductor-on-insulator technology as is known in the art such that no further explanation is required for a complete understanding of the present disclosure.

The semiconductor substrate 16 may include an n-type triple well isolation structure 18. In embodiments, the n-type triple well isolation structure 18 may be provided for the heterojunction bipolar transistor 200. In embodiments, the n-type triple well isolation structure 18 may be formed by a conventional ion implantation process. For example, the n-type triple well isolation structure 18 may be formed by introducing an N-type dopant by, for example, ion implantation that introduces a concentration of a dopant in the semiconductor substrate 16.

In an ion implantation process, patterned implantation masks may be used to define selected areas exposed for the implantations. The implantation masks may include a layer of a light-sensitive material, such as an organic photoresist, applied by a spin coating process, pre-baked, exposed to light projected through a photomask, baked after exposure, and developed with a chemical developer. The implantation masks have a thickness and stopping power sufficient to block masked areas against receiving a dose of the implanted ions. The n-type triple well isolation structure 18 is doped with n-type dopants, e.g., Arsenic (As), Phosphorus (P) and Antimony (Sb), among other suitable examples. An annealing process may be performed to drive in the dopants into the semiconductor substrate 16.

Still referring to FIG. 1, the heterojunction bipolar transistors 100, 200 further include sub-collector regions 20a, 20b, respectively, in the semiconductor substrate 16. In embodiments, the sub-collector regions 20a, 20b are for the respective heterojunction bipolar transistors 100, 200. For example, the sub-collector region 20a of the heterojunction bipolar transistor 100 may have an N-type doping and the sub-collector region 20b of the heterojunction bipolar transistor 200 may have a P-type doping. As already noted herein, the doping of the sub-collector regions 20a, 20b may be provided by an ion implantation process with different masks and different dopant type such that no further explanation is required herein for a complete understanding of the present disclosure.

Trench isolation structures 22 may be provided in the semiconductor substrate 16. In embodiments, the trench isolation structures 22 may be either shallow trench isolation structures or deep trench isolation structures, depending on the thickness of the sub-collector regions 20a, 20b. With this noted, the trench isolation structures 22 may be used to isolate the collector regions 20a, 20b from other devices (passive or active) of the structure 10.

The trench isolation structures 22 may be formed by conventional lithography, etching and deposition methods known to those of skill in the art. For example, a resist formed over the semiconductor substrate 16 is exposed to energy (light) and developed utilizing a conventional resist developer to form a pattern (opening). An etching process with a selective chemistry, e.g., reactive ion etching (RIE), may be used to transfer the pattern from the patterned photoresist layer to the semiconductor substrate 16 to form one or more trenches in the semiconductor substrate 16 through the openings of the resist. Following the resist removal by a conventional oxygen ashing process or other known stripants, the insulator material (e.g., oxide based material) can be deposited by any conventional deposition processes, e.g., chemical vapor deposition (CVD) processes. Any residual material on the surface of the semiconductor substrate 16 can be removed by conventional chemical mechanical polishing (CMP) processes.

FIG. 1 further shows insulator material 24 over the semiconductor substrate 16 and, more specifically, over both the sub-collector regions 20a, 20b. In embodiments, the insulator material 24 may be any dielectric material such as, for example, nitride, oxide or a combination thereof. For example, the insulator material 24 may be a stack of oxide and nitride materials. The insulator material 24 may be patterned to form trenches 26 exposing both the sub-collector regions 20a, 20b for formation of the intrinsic base regions. The patterning may be used to expose the underlying sub-collector regions 20a, 20b for subsequent formation of collector contacts 28.

In embodiments, the trenches 26 are filled with semiconductor material 30. In embodiments, the semiconductor material 30 may be intrinsic Si. The semiconductor material 30 may be epitaxially grown on the surfaces of the sub-collector regions 20a, 20b. An additional semiconductor material 14a, 14b may be grown over and in contact with the respective sub-collector regions 20a, 20b. In embodiments, the additional semiconductor material 14a, 14b may act as an intrinsic base for the respective heterojunction bipolar transistors 100, 200. The additional semiconductor material 14a, 14b may be SiGe material that is doped with different dopants for the respective heterojunction bipolar transistors 100, 200. For example, the semiconductor material 14a may be P-doped SiGe and the semiconductor material 14b may be N-doped SiGe. In further embodiments, the semiconductor material 14a, 14b may be epitaxially grown with an in-situ doping process as is known in the art.

By way of example, various epitaxial growth process apparatuses can be employed in the present application include, e.g., rapid thermal chemical vapor deposition (RTCVD), low-energy plasma deposition (LEPD), ultra-high vacuum chemical vapor deposition (UHVCVD), atmospheric pressure chemical vapor deposition (APCVD) and molecular beam epitaxy (MBE). The epitaxial growth may be performed at a temperature of from 300° C. to 800° C. The epitaxial growth can be performed utilizing any well-known precursor gas or gas mixture. Carrier gases like hydrogen, nitrogen, helium and argon can be used. A dopant (n-type or p-type, as defined below) is typically added to the precursor gas or gas mixture.

Still referring to FIG. 1, the heterojunction bipolar transistors 100, 200 also include a shared extrinsic base region 12 (e.g., base regions 12a, 12b) connecting to respective intrinsic base regions 14a, 14b of each heterojunction bipolar transistors 100, 200. The shared extrinsic base region 12 may be planar and comprises different doping (e.g., N-type doping and P-type doping) for each of the heterojunction bipolar transistors 100, 200. For example, the shared and continuous extrinsic base region 12a comprises a P-type doping, e.g., Boron, and the shared extrinsic base region 12b comprises an N-type doping, e.g., Arsenic. The shared extrinsic base regions 12a, 12b may be separated by an intrinsic semiconductor material 12c. In embodiments, the intrinsic semiconductor material 12c may be the same or different semiconductor material of the shared extrinsic base regions 12a, 12b, e.g., Si or polysilicon material.

The heterojunction bipolar transistors 100, 200 further include emitter regions 32a, 32b. In embodiments, the emitter regions 32a, 32b electrically connect, e.g., contact, the respective intrinsic base regions 14a, 14b. The emitter regions 32a, 32b may be polysilicon material with different doping types. For example, the emitter region 32a may be an N-type emitter region and the emitter region 32b may be a P-type emitter region. In embodiments, the emitter regions 32a, 32b may be isolated from the extrinsic base regions 12a, 12b by sidewall spacers 34 and underlying insulator material. The sidewall spacers 34 may be an insulator material, e.g., nitride, oxide or combinations thereof. The sidewall spacers 34 may be formed by conventional deposition processes, e.g., CVD, followed by a conventional etching process, e.g., RIE.

Contacts 28, 36, 38 may be formed to the respective sub-collector regions 20a, 20b, extrinsic base regions 12a, 12b and the emitter regions 32a, 32b. Prior to forming the contacts 28, 36, 38 a silicide contact 40 may be formed on the exposed semiconductor surfaces of the respective sub-collector regions 20a, 20b, extrinsic base regions 12a, 12b and the emitter regions 32a, 32b.

As should be understood by those of skill in the art, the silicide process begins with deposition of a thin transition metal layer, e.g., nickel, cobalt or titanium, over exposed semiconductor material. After deposition of the material, the structure is heated allowing the transition metal to react with exposed silicon (or other semiconductor material as described herein) in the active regions of the semiconductor device (e.g., respective sub-collector regions 20a, 20b, extrinsic base regions 12a, 12b and the emitter regions 32a, 32b) forming a low-resistance transition metal silicide. Following the reaction, any remaining transition metal is removed by chemical etching, leaving silicide contacts in the active regions of the device.

The contacts 28, 36, 36a, 38 may be formed in interlevel dielectric material 42. The interlevel dielectric material 42 may be formed by conventional deposition processes., e.g., CVD. The interlevel dielectric material 42 may be layers of oxide and nitride material as is known in the art. The contacts 28, 36, 36a, 38 may be formed by patterning of the interlevel dielectric material 42 followed by a deposition of conductive material within trenches formed by the patterning process as is known in the art such that no further explanation is required herein for a complete understanding of the present disclosure. The conductive material may be tungsten, TiN, TaN, etc. The contact 36a may also span across the intrinsic semiconductor material 12c and connect to both of the emitter regions 32a, 32b.

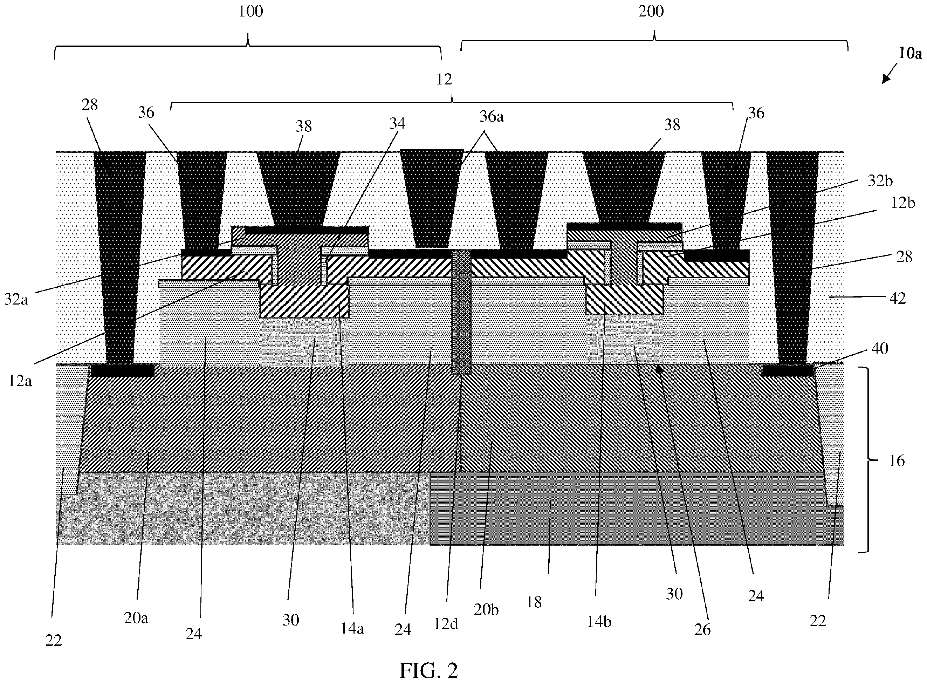

FIG. 2 shows a structure and respective fabrication processes in accordance with additional aspects of the present disclosure. In the structure 10a of FIG. 2, semiconductor material 12d may be used to separate the extrinsic base regions 12a, 12b. In embodiments, two contacts 36a may be used to connect to the respective emitter regions 32a, 32b; although a single contact may also be used which would span over the semiconductor material 12b. the silicide contacts for the different extrinsic base regions 12a, 12b may also be separated, e.g., isolated from each other.

The semiconductor material 12d may extend through the insulator material 24 and contact to the sub-collector regions 20a, 20b by performing an etching process to a certain depth followed by a deposition process, e.g., CVD. In alternative embodiments, the semiconductor material 12d may extend to the surface of the insulator material 24 or other depths of the structure. The semiconductor material 12d may link the extrinsic base regions 12a, 12b with the intrinsic base regions 14a, 14b. The semiconductor material 12d may be selective epitaxial semiconductor material and, more specifically, intrinsic Si material, e.g., fully undoped, or in-situ doped Si, or SiGe material. 12d may also be an insulator material separating the two extrinsic base regions. The remaining features of the structure 10a of FIG. 2 are similar to the features of the structure 10 of FIG. 1 such that no further explanation is required for a complete understanding of the present disclosure.

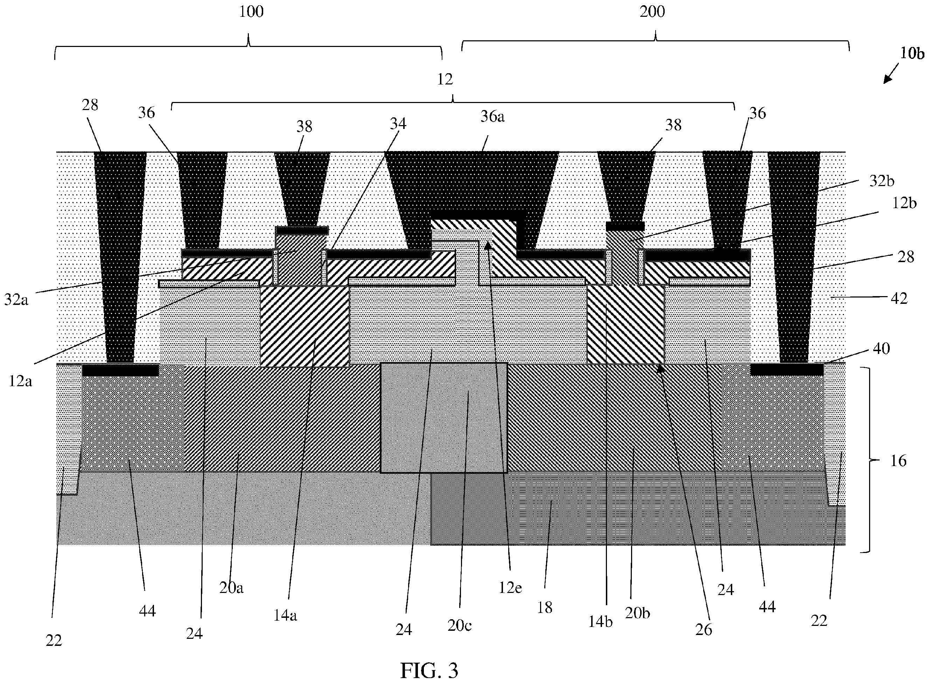

FIG. 3 shows a structure and respective fabrication processes in accordance with additional aspects of the present disclosure. In the structure 10b of FIG. 3, the extrinsic base regions 12a, 12b overlap as shown at reference numeral 12e. In this configuration, the overlapped region 12e will result in a smaller footprint of the complementary heterojunction bipolar transistors 100, 200. In this embodiment, the extrinsic base region 12b may be raised above and overlapped with the extrinsic base region 12a; although it is contemplated that the extrinsic base region 12a may be raised above and overlapped with the extrinsic base region 12b. Also, portions of the extrinsic base region 12, 12b remain planar.

As further shown in FIG. 3, insulator material 24 may separate the extrinsic base regions 12a, 12b. It should be understood that the insulator material 24 may be a stack of dielectric material such as oxide and nitride layers. In this embodiment, the contact 36a may be shared with both the emitter regions 32a, 32b; although two separate contacts are also contemplated as described with respect to FIG. 2. In addition, an undoped semiconductor region 20 may be provided between the sub-collector regions 20a, 20b. In addition, heavily doped regions 44 of respective n-type and p-type dopant matching that of the collector regions 20a, 20b may be underneath the collector contacts 28. The heavily doped regions 44 may also be present in the structures of FIGS. 1 and 2. The remaining features of structure 10b of FIG. 3 are similar to the features of the structure 10 of FIG. 1 such that no further explanation is required for a complete understanding of the present disclosure.

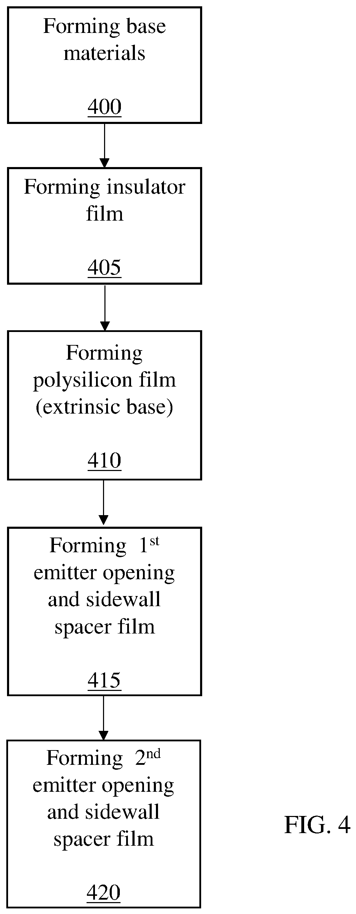

FIG. 4 shows a flow diagram representing partial fabrication processes for forming the heterojunction bipolar transistor of FIG. 1. It should be recognized by those of skill in the art that other fabrication steps may be used to complete the heterojunction bipolar transistor and that the flow diagram focuses on the formation of the base and the emitter regions. The remaining steps have already described with respect to FIG. 1. In addition, the flow diagram of FIG. 4 may be used to fabricate the structure shown in FIG. 2, with additional etching and deposition steps to form region 12d.

At step 400, an NPN base epitaxial semiconductor material and PNP base epitaxial semiconductor material may be grown within trenches of the insulator material 24, which exposes the underlying sub-collector regions 20a, 20b. In embodiments, the epitaxial semiconductor materials may be intrinsic Si material and doped SiGe material over the intrinsic Si material. In this way, the intrinsic base regions may be surrounded laterally by the insulator material 24. In embodiments, the epitaxial material may be grown by conventional epitaxial growth processes with the upper epitaxial semiconductor material, e.g., SiGe, being subjected to a respective in-situ doping processes to form the intrinsic base 14a, 14b. A nitride film may be used to protect the underlying insulator material 24 during this epitaxial process, which may be removed by, for example, hot phosphorous.

At step 405, an insulator (e.g., oxide) film may be deposited on the epitaxial semiconductor material, followed by a patterning process to expose the underlying epitaxial semiconductor material. A polysilicon film may be deposited over the insulator material 24. In embodiments, the insulator (e.g., oxide) film and polysilicon film may be deposited by a conventional deposition method, e.g., CVD.

At step 410, the polysilicon material may be subjected to different dopant types through different ion implantation processes, as described herein, to form the extrinsic base regions 12a, 12b. For example, the ion implantation process for the NPN will use a P-type dopant, e.g., Boron, and the ion implantation process for the PNP will use an N-type dopant, e.g., Arsenic. It should be recognized that the polysilicon film used for the extrinsic base 12a, 12b has a planar and continuous surface. In embodiments, the masks used in the different ion implantation processes will block portions of the polysilicon material from being implanted, forming the intrinsic semiconductor material 12c shown in FIG. 1.

At step 415, an insulator material (e.g., mask) may be formed over the polysilicon film, and the polysilicon film and insulator material may be subjected to an etching process to form an emitter opening in the polysilicon film on an NPN (or PNP) side of the device. In embodiments, the etching process is a conventional lithography and etching process as described herein. A spacer sidewall material, e.g., oxide or nitride or combinations thereof, may be deposited and patterned to form the sidewall spacers 34. For example, a spacer sidewall material may be blanket deposited on the structure, including with the emitter opening, by a CVD process. The spacer sidewall material may undergo an anisotropic etching process to form the sidewall spacers 34. An emitter material may be grown within the opening and on the insulator material and the sidewall spacers, using an in-situ doping to form the emitter 32a.

At step 420, the polysilicon film and insulator material may be subjected to another etching process to form an emitter opening in the polysilicon film on a PNP side (or NPN) of the device. In embodiments, the etching process is a conventional lithography and etching process as described herein. A spacer sidewall material, e.g., oxide or nitride or combinations thereof, may be formed on the sidewalls of the opening to form the sidewall spacers 34 as described above. An emitter material may be grown within the opening and on the insulator material, using an in-situ doping to form the emitter 32b. It should be recognized that steps 415 and 420 may be reversed.

The polysilicon film for both the emitters 32a, 32b are planar and may be subjected to an etching process to pattern them according to a specific design configuration. Silicide and contacts may be fabricated as described with respect to FIG. 1.

The structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

In summary, the present disclosure relates to semiconductor structures and, more particularly, to heterojunction bipolar transistors and methods of manufacture. The structure includes: a first transistor having an intrinsic base, an extrinsic base and an emitter; and a second transistor having an intrinsic base, an extrinsic base and an emitter. The extrinsic base of the first transistor and the extrinsic base of the second transistor have a common extrinsic base layer with a first dopant type for the first transistor and a second dopant type for the second transistor.

The following embodiments are explicitly disclosed.

### Embodiment 1:

A structure, comprising:
a first transistor comprising an intrinsic base, an extrinsic base and an emitter; and
a second transistor comprising an intrinsic base, an extrinsic base and an emitter,
wherein the extrinsic base of the first transistor and the extrinsic base of the second transistor comprise a common extrinsic base layer with a first dopant type for the first transistor and a second dopant type for the second transistor.

### Embodiment 2:

The structure of embodiment 1, wherein the extrinsic base of the first transistor and the extrinsic base of the second transistor are coplanar.

### Embodiment 3:

The structure of embodiment 1 or 2, wherein the first dopant type is an N-type dopant and the second dopant type is a P-type dopant.

### Embodiment 4:

The structure of one of embodiments 1 to 3, wherein the common extrinsic base is a continuous semiconductor base material between the first transistor and the second transistor.

### Embodiment 5:

The structure of embodiment 4, further comprising a semiconductor material isolating the first dopant type of the first transistor from the second dopant type of the second transistor.

### Embodiment 6:

The structure of one of embodiments 1 to 5, wherein the first transistor and the second transistor comprise complementary NPN and PNP heterojunction bipolar transistors.

### Embodiment 7:

The structure of embodiment 6, wherein the PNP heterojunction bipolar transistor includes a triple well.

### Embodiment 8:

The structure of embodiment 6 or 7, wherein the first transistor includes a subcollector region with the second dopant type and the second transistor includes a subcollector region with the first dopant type.

### Embodiment 9:

The structure of one of embodiments 1 to 8, further comprising a common contact connecting to the extrinsic base of the first transistor and the extrinsic base of the second transistor.

### Embodiment 10:

The structure of embodiment 9, wherein the common contact extends over a semiconductor region separating the extrinsic base of the first transistor and the extrinsic base of the second transistor.

### Embodiment 11:

The structure of one of embodiments 1 to 10, further comprising a first silicide contact on the extrinsic base of the first transistor and a second silicide contact on the extrinsic base of the second transistor, wherein the first silicide contact and the second silicide contact are separated from each other.

### Embodiment 12:

The structure of one of embodiments 1 to **11,** further comprising a single silicide contact extending over both the extrinsic base of the first transistor and the extrinsic base of the second transistor.

### Embodiment 13:

The structure of one of embodiments 1 to 12, wherein the extrinsic base of the first transistor extends above and overlaps with the extrinsic base of the second transistor.

### Embodiment 14:

A structure comprising:
a first heterojunction bipolar transistor comprising an emitter with a first dopant type, an extrinsic base with a second dopant type and a sub-collector region with the first dopant type; and
a second heterojunction bipolar transistor comprising an emitter with the second dopant type, an extrinsic base with the first dopant type and a sub-collector region with the second dopant type,
wherein the extrinsic base of the first heterojunction bipolar transistor and the extrinsic base of the second heterojunction bipolar transistor comprise a common and continuous semiconductor layer.

### Embodiment 15:

The structure of embodiment 14, wherein the extrinsic base of the first heterojunction bipolar transistor is coplanar with the extrinsic base of the second heterojunction bipolar transistor.

### Embodiment 16:

The structure of embodiment 14 or 15, wherein the first dopant type is an N-type dopant and the second dopant type is a P-type dopant.

### Embodiment 17:

The structure of one of embodiments 14 to 16, further comprising a semiconductor material isolating the extrinsic base of the first heterojunction bipolar transistor from the extrinsic base of the second heterojunction bipolar transistor.

### Embodiment 18:

The structure of one of embodiments 14 to 17, wherein the first heterojunction bipolar transistor and the second heterojunction bipolar transistor comprise complementary NPN and PNP heterojunction bipolar transistors, wherein the PNP heterojunction bipolar transistor further includes a n-triple well.

### Embodiment 19:

The structure of one of embodiments 14 to 18, wherein the extrinsic base of the first heterojunction bipolar transistor extends above and overlaps with the extrinsic base of the second heterojunction bipolar transistor.

### Embodiment 20:

A structure, comprising:
a first transistor comprising an intrinsic base, an extrinsic base and an emitter; and
a second transistor comprising an intrinsic base, an extrinsic base and an emitter,
wherein the extrinsic base of the first transistor and the extrinsic base of the second transistor comprise a common and continuous semiconductor layer, and/or
wherein the extrinsic base of the first transistor and the extrinsic base of the second transistor comprise a common extrinsic base layer with a first dopant type for the first transistor and a second dopant type for the second transistor.

### Embodiment 21:

The structure of embodiment 20, wherein the extrinsic base of the first transistor and the extrinsic base of the second transistor are coplanar, and/or
wherein the first dopant type is an N-type dopant and the second dopant type is a P-type dopant or vice versa.

### Embodiment 22:

The structure of embodiment 20 or 21, wherein the common extrinsic base is a continuous semiconductor base material between the first transistor and the second transistor.

### Embodiment 23:

The structure of one of embodiments 20 to 22, further comprising a semiconductor material isolating the first dopant type of the first transistor from the second dopant type of the second transistor.

### Embodiment 24:

The structure of one of embodiments 20 to 23, wherein the first transistor and the second transistor comprise complementary NPN and PNP heterojunction bipolar transistors.

### Embodiment 25:

The structure of embodiment 24, wherein the PNP heterojunction bipolar transistor includes a triple well, and/or
wherein the first transistor includes a subcollector region with the second dopant type and the second transistor includes a subcollector region with the first dopant type.

### Embodiment 26:

The structure of one of embodiments 20 to 25, further comprising a common contact connecting to the extrinsic base of the first transistor and the extrinsic base of the second transistor
wherein the common contact preferably extends over a semiconductor region separating the extrinsic base of the first transistor and the extrinsic base of the second transistor.

### Embodiment 27:

The structure of one of embodiments 20 to 26, further comprising a first silicide contact on the extrinsic base of the first transistor and a second silicide contact on the extrinsic base of the second transistor, wherein the first silicide contact and the second silicide contact are separated from each other.

### Embodiment 28:

The structure of one of embodiments 20 to 27, further comprising a single silicide contact extending over both the extrinsic base of the first transistor and the extrinsic base of the second transistor.

### Embodiment 29:

The structure of one of embodiments 20 to 28, wherein the extrinsic base of the first transistor extends above and overlaps with the extrinsic base of the second transistor.

### Embodiment 30:

The structure of one of embodiments 20 to 29, wherein:
the first transistor is a first heterojunction bipolar transistor comprising an emitter with a first dopant type, an extrinsic base with a second dopant type and a sub-collector region with the first dopant type; and
the second transistor is a second heterojunction bipolar transistor comprising an emitter with the second dopant type, an extrinsic base with the first dopant type and a sub-collector region with the second dopant type,
wherein the extrinsic base of the first heterojunction bipolar transistor and the extrinsic base of the second heterojunction bipolar transistor comprise the common and continuous semiconductor layer,
the first dopant type preferably being an N-type dopant and the second dopant type preferably being a P-type dopant.

### Embodiment 31:

The structure of embodiment 30, further comprising a semiconductor material isolating the extrinsic base of the first heterojunction bipolar transistor from the extrinsic base of the second heterojunction bipolar transistor.

### Embodiment 32:

The structure of embodiment 30 or 31, wherein the first heterojunction bipolar transistor and the second heterojunction bipolar transistor comprise complementary NPN and PNP heterojunction bipolar transistors, wherein the PNP heterojunction bipolar transistor further includes a n-triple well.

### Embodiment 33:

The structure of one of embodiments 30 to 32, wherein the extrinsic base of the first heterojunction bipolar transistor extends above and overlaps with the extrinsic base of the second heterojunction bipolar transistor.

### Embodiment 34:

A method comprising:
forming a first transistor comprising an intrinsic base, an extrinsic base and an emitter; and
forming a second transistor an intrinsic base, an extrinsic base and an emitter,
wherein the extrinsic base of the first transistor and the extrinsic base of the second transistor are formed with a common extrinsic base layer with a first dopant type for the first transistor and a second dopant type for the second transistor.

### Embodiment 35:

The method of embodiment 34, wherein the structure of one of embodiments 1 to 33 is formed.

## Claims

1. A structure, comprising:
a first transistor comprising an intrinsic base, an extrinsic base and an emitter; and
a second transistor comprising an intrinsic base, an extrinsic base and an emitter,
wherein the extrinsic base of the first transistor and the extrinsic base of the second transistor comprise a common and continuous semiconductor layer, and/or
wherein the extrinsic base of the first transistor and the extrinsic base of the second transistor comprise a common extrinsic base layer with a first dopant type for the first transistor and a second dopant type for the second transistor.

2. The structure of claim 1, wherein the extrinsic base of the first transistor and the extrinsic base of the second transistor are coplanar, and/or
wherein the first dopant type is an N-type dopant and the second dopant type is a P-type dopant or vice versa.

3. The structure of claim 1 or 2, wherein the common extrinsic base is a continuous semiconductor base material between the first transistor and the second transistor.

4. The structure of one of claims 1 to 3, further comprising a semiconductor material isolating the first dopant type of the first transistor from the second dopant type of the second transistor.

5. The structure of one of claims 1 to 4, wherein the first transistor and the second transistor comprise complementary NPN and PNP heterojunction bipolar transistors.

6. The structure of claim 5, wherein the PNP heterojunction bipolar transistor includes a triple well, and/or
wherein the first transistor includes a subcollector region with the second dopant type and the second transistor includes a subcollector region with the first dopant type.

7. The structure of one of claims 1 to 6, further comprising a common contact connecting to the extrinsic base of the first transistor and the extrinsic base of the second transistor
wherein the common contact preferably extends over a semiconductor region separating the extrinsic base of the first transistor and the extrinsic base of the second transistor.

8. The structure of one of claims 1 to 7, further comprising a first silicide contact on the extrinsic base of the first transistor and a second silicide contact on the extrinsic base of the second transistor, wherein the first silicide contact and the second silicide contact are separated from each other.

9. The structure of one of claims 1 to 8, further comprising a single silicide contact extending over both the extrinsic base of the first transistor and the extrinsic base of the second transistor.

10. The structure of one of claims 1 to 9, wherein the extrinsic base of the first transistor extends above and overlaps with the extrinsic base of the second transistor.

11. The structure of one of claims 1 to 10, wherein:
the first transistor is a first heterojunction bipolar transistor comprising an emitter with a first dopant type, an extrinsic base with a second dopant type and a sub-collector region with the first dopant type; and
the second transistor is a second heterojunction bipolar transistor comprising an emitter with the second dopant type, an extrinsic base with the first dopant type and a sub-collector region with the second dopant type,
wherein the extrinsic base of the first heterojunction bipolar transistor and the extrinsic base of the second heterojunction bipolar transistor comprise the common and continuous semiconductor layer,
the first dopant type preferably being an N-type dopant and the second dopant type preferably being a P-type dopant.

12. The structure of claim 11, further comprising a semiconductor material isolating the extrinsic base of the first heterojunction bipolar transistor from the extrinsic base of the second heterojunction bipolar transistor.

13. The structure of claim 11 or 12, wherein the first heterojunction bipolar transistor and the second heterojunction bipolar transistor comprise complementary NPN and PNP heterojunction bipolar transistors, wherein the PNP heterojunction bipolar transistor further includes a n-triple well.

14. The structure of one of claims 11 to 13, wherein the extrinsic base of the first heterojunction bipolar transistor extends above and overlaps with the extrinsic base of the second heterojunction bipolar transistor.

15. A method comprising:
forming a first transistor comprising an intrinsic base, an extrinsic base and an emitter; and
forming a second transistor an intrinsic base, an extrinsic base and an emitter,
wherein the extrinsic base of the first transistor and the extrinsic base of the second transistor are formed with a common extrinsic base layer with a first dopant type for the first transistor and a second dopant type for the second transistor.
